# EUROPÄISCHE PATENTSCHRIFT

(11) **EP 0 934 687 B1**
(45) Veröffentlichungstag und Bekanntmachung des Hinweises auf die Patenterteilung: **05.11.2003**
(21) Anmeldenummer: 98936156.3
(22) Anmeldetag: 12.06.1998
(51) Int. Cl.: H05K 7/20

(54) **ANORDNUNG, UMFASSEND EIN TRÄGERSUBSTRAT FÜR LEISTUNGSBAUELEMENTE UND EINEN KÜHLKÖRPER SOWIE VERFAHREN ZUR HERSTELLUNG DERSELBEN**
ASSEMBLY CONSISTING OF A SUBSTRATE FOR POWER COMPONENTS AND A COOLING ELEMENT AND METHOD FOR THE PRODUCTION THEREOF
ENSEMBLE COMPRENANT UN SUBSTRAT POUR DES COMPOSANTS DE PUISSANCE ET UN ELEMENT DE REFROIDISSEMENT, ET PROCEDE POUR PRODUIRE LEDIT ENSEMBLE

(30) Priorität: 25.08.1997 DE 19736962
(43) Veröffentlichungstag der Anmeldung: 11.08.1999
(73) Patentinhaber: ROBERT BOSCH GMBH, 70442 Stuttgart (DE)
(72) Erfinder: WEBER, Bernd, D-74232 Abstatt (DE); HOFSAESS, Dietmar, D-71522 Backnang (DE); BUTSCHKAU, Werner, D-74321 Bietigheim-Bissingen (DE); DITTRICH, Thomas, D-75242 Neuhausen (DE); SCHIEFER, Peter, D-74199 Untergruppenbach (DE)
(86) Internationale Anmeldenummer: DE9801609
(87) Internationale Veröffentlichungsnummer: WO99011107

(56) Entgegenhaltungen:
- DE-A- 2 528 000
- DE-A- 19 528 632
- DE-U- 9 308 842
- US-A- 5 646 826

## Beschreibung

### Stand der Technik

Die Erfindung betrifft eine Anordnung mit einem Trägersubstrat für Leistungsbauelemente und einem Kühlkörper mit den im Oberbegriff des Anspruchs 1 angegebenen Merkmalen sowie ein Verfahren zu deren Herstellung.

Eine derartige Anordnung ist bereits aus der Druckschrift DE 195 28 632 A1 bekannt. Als Trägersubstrat ist in dieser Druckschrift eine Leiterplatte gezeigt, die auf ihrer Oberseite mit einer elektronischen Schaltung versehen ist, die wenigstens ein Verlustwärme erzeugendes Leistungsbauelement umfaßt. Unterhalb des Leistungsbauelementes ist die Leiterplatte mit Durchkontaktierungen versehen, welche die von dem Leistungsbauelement erzeugte Wärme auf die Unterseite der Leiterplatte ableiten. Zwischen der Unterseite der Leiterplatte und einem als Kühlkörper dienenden Steuergerätegehäuse ist ein wärmeleitender Füllstoff angeordnet. Im Betrieb wird die von dem Leistungsbauelement erzeugte Wärme über die Durchkontaktierungen auf die Unterseite der Leiterplatte abgeleitet und von dort über den wärmeleitenden Füllstoff an das als Kühlkörper dienende Gehäuse abgegeben. Nachteilig dabei ist, daß potentialführende Leiterbahnen auf der Unterseite der Leiterplatte bei der Montage der Leiterplatte im Steuergerät mit dem Kühlkörper in Kontakt gelangen können. Ein hierdurch verursachter Kurzschluß kann die empfindlichen elektronischen Bauteile auf der Leiterplatte beschädigen oder zerstören.

Weiterhin ist in der deutschen Patentanmeldung DE 1 97 23 409 eine Anordnung mit einem Trägersubstrat und einem Kühlkörper gezeigt. Auf der Oberseite der Leiterplatte ist ein Leistungsbauelement auf eine großflächige Leiterbahn aufgebracht, die über Durchkontaktierungen mit einer großflächigen Leiterbahn auf der Unterseite der Leiterplatte verbunden ist. Auf der Unterseite der Leiterplatte ist unter die dort angeordnete großflächige Leiterbahn über eine Isolationsschicht eine Metallschicht aufgebracht, die wiederum über eine Lötstoppmaske auf ein als Kühlkörper vorgesehenes Gehäuseteil eines Steuergerätes aufgesetzt ist. Bei einer derartigen Anordnung wird zwar ein elektrischer Kontakt zwischen den Leiterbahnen und dem Kühlkörper durch die Isolationsschicht verhindert, als nachteilig muß aber angesehen werden, daß die Isolationsschicht und die weitere Metallschicht die direkte Wärmeübertragung auf den Kühlkörper erschweren, den Platzbedarf der Anordnung erhöhen und außerdem die Herstellungskosten verteuern.

### Vorteile der Erfindung

Die erfindungsgemäße Anordnung mit den kennzeichnenden Merkmalen des Anspruchs 1 vermeidet die beim Stand der Technik auftretenden Nachteile. Durch auf der den Leistungsbauelementen gegenüberliegenden Seite des Trägersubstrats aufgebrachte Abstandselemente und einen zwischen das Trägersubstrat und den Kühlkörper eingebrachten wärmeleitenden Füllstoff, wird vorteilhaft einerseits eine gute Wärmeankopplung des Trägersubstrats an den Kühlkörper erreicht und andererseits ein unerwünschter elektrischer Kontakt zwischen den auf dieser Seite des Trägersubstrats befindlichen, potentialführenden Leiterbahnen und dem Kühlkörper zuverlässig vermieden. Außerdem kann mit der vorgeschlagenen Lösung eine besonders platzsparende Anordnung realisiert werden. Zusätzliche die Herstellung verteuernde Schichten, wie z.B. eine zusätzliche Isolationsschicht oder eine weitere auf die Isolationsschicht aufgebrachte Metallschicht, sind nicht erforderlich, so daß die Kosten hierfür eingespart werden können.

Besonderes vorteilhaft ist weiterhin, wenn die Abstandselemente aus Leiterflächenstücken auf der Unterseite des Trägersubstrats bestehen, die mit einer definierten Menge Lot beschichtet sind, da hierfür insbesondere bei beidseitig bestückten Trägersubstraten kein zusätzlicher Herstellungsschritt erforderlich ist. Die Leiterflächenstücke können zusammen mit den Anschlußflächen von auf der Unterseite vorgesehenen elektronischen Bauelementen hergestellt und mit Lot beschichtet werden.

Ein auf der den Leistungsbauelementen gegenüberliegenden Seite des Trägersubstrats aufgebrachter Lötstopplack verhindert, daß bei der Lotauf tragung versehentlich Lot auf die nicht dafür vorgesehene Stellen gelangt.

Wenn sich das Leistungsbauelement und der Kühlkörper auf gleichem elektrischen Potential befinden, ist es vorteilhaft die Leiterflächenstücke direkt in der zweiten großflächigen Leiterbahn integriert herzustellen, da hierdurch der Wärmeübergang verbessert wird.

Vorteilhaft ist weiterhin, wenn der zwischen dem Trägersubstrat und dem Kühlkörper vorgesehene wärmeleitende Füllstoff ein Wärmeleitkleber oder eine wärmeleitende Klebefolie ist, durch den das Trägersubstrat auch mechanisch auf dem Kühlkörper befestigt werden kann.

Die auf dem Kühlkörper aufliegenden Abstandselemente können vorteilhaft auch als Masseanschluß des Trägersubstrats an den Kühlkörper und zur Verbesserung des EMV-Verhaltens (Elektromagnetische Verträglichkeit) genutzt werden.

Die Erfindung betrifft ferner ein Verfahren zur Herstellung einer Anordnung aus einem Trägersubstrat und einem Kühlkörper. Insbesondere bei beidseitig bestückten Trägersubstraten sind zur Durchführung des Verfahrens keine zusätzlichen Herstellungsschritte erforderlich. Die Leiterflächenstücke können zusammen mit auf der zweiten Seite vorgesehen Leiterbahnen hergestellt werden. Die für die Herstellung der Abstandselemente notwendige Abscheidung von Lot kann auf den Leiterflächenstücken zusammen mit der Belotung von Anschlußflächen für Bauelemente durchgeführt werden, wodurch das Verfahren besonders wirtschaftlich wird, da zur Herstellung der Abstandselemente kaum zusätzliche Kosten entstehen.

Vorteilhaft ist, das Lot in einer Lötpastendruckstation auf die Leiterflächenstücke aufzudrucken, da diese Technik besonders gut zur Abscheidung einer definierten Menge Lotes geeignet ist und gut beherrschbar ist. In einem anschließenden Reflowlötschritt wird das Lot aufgeschmolzen, wobei sich Abstandselemente mit einer durch die aufgetragene Lotmenge definierten Höhe bilden. Vorteilhaft kann der Reflowlötschritt zusammen mit der Reflowlötung von auf dem Trägersubstrat vorgesehenen SMD-Bauelementen erfolgen.

Besonders leicht ist es, einen wärmeleitenden Kleber oder eine wärmeleitende Klebefolie zunächst auf den Kühlkörper aufzutragen und anschließend das Trägersubstrat auf den mit dem Kleber bzw. der Klebefolie beschichteten Kühlkörper derart aufzusetzen, daß die Abstandselemente in den Kleber eingedrückt werden, wobei sie mit der Lotschicht den Kühlkörper kontaktieren können.

### Zeichnung

Ein Ausführungsbeispiel der Erfindung ist in der Zeichnung dargestellt und wird in der nachfolgenden Beschreibung näher erläutert. Es zeigt
Fig. 1 einen vereinfachten Querschnitt einer aus dem Stand der Technik bekannten Anordnung mit einer Isolationsschicht und einer zusätzlichen Kupferplatte,
Fig. 2 einen vereinfachten Querschnitt einer erfindungsgemäßen Anordnung,
Fig. 3 einen vereinfachten Querschnitt der erfindungsgemäßen Annordnung für ein zweites Ausführungsbeispiel.

### Beschreibung der Ausführungsbeispiele

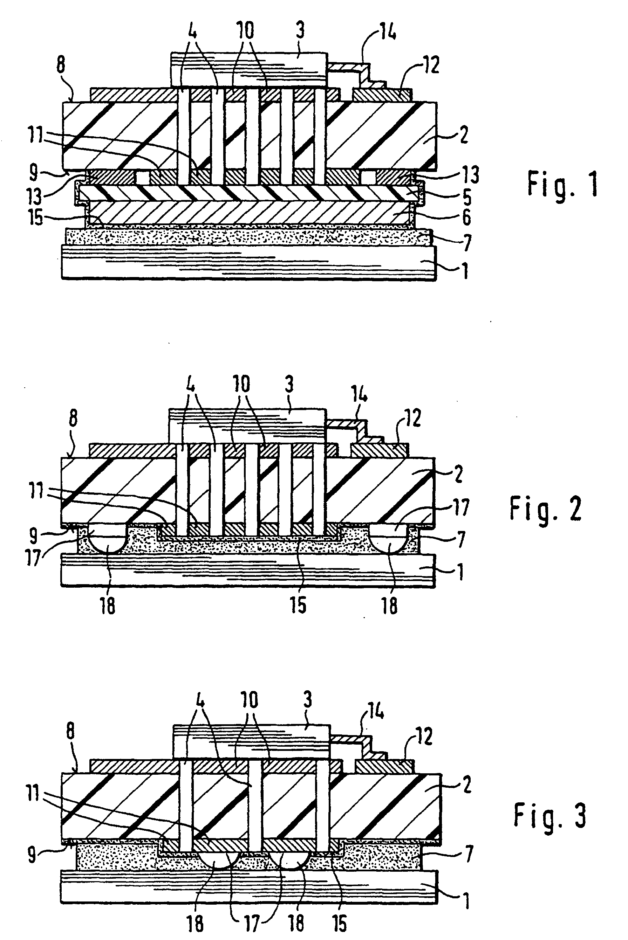

Fig. 1 zeigt eine aus dem Stand der Technik bekannte Anordnung zur Ableitung der durch ein Leistungsbauelement erzeugten Verlustwärme in einem Steuergerät. Eine Leiterplatte 2 ist auf der nach oben gewandten ersten Seite 8 mit einer ersten großflächigen Leiterbahn 10 und auf der nach unten gewandten zweiten Seite 9 mit einer zweiten großflächigen Leiterbahn 11 versehen. Die erste großflächige Leiterbahn 10 und die zweite großflächige Leiterbahn 11 sind über zahlreiche sich durch die Leiterplatte erstreckende Durchkontaktierungen 4 gut wärmeleitend miteinander verbunden. Auf die erste großflächige Leiterbahn 10 ist ein Leistungsbauelement 3 z.B. ein SMD-Bauelement aufgebracht, das über Anschlüsse 14 mit weiteren, von der großflächigen Leiterbahn 10 isolierten Leiterbahnen 12 auf der Oberseite 8 der Leiterplatte 2 leitend verbunden ist. Der Einfachheit halber ist nur eine Leiterbahn 12 dargestellt. Auf der Unterseite 9 befinden sich noch weitere potentialführende Leiterbahnen 13, die von der zweiten großflächigen Leiterbahn 11 isoliert angeordnet sind. Außerdem sind auf der Unterseite 9 noch weitere nicht dargestellte SMD-Bauelemente vorgesehen, die mit nicht gezeigten Anschlußflächen auf der Unterseite verlötet sind. Weiterhin ist eine als Wärmesenke dienende Kupferplatte 6 über eine elektrisch isolierende, wärmeleitende Isolationsschicht 5 auf die zweite großflächige Leiterbahn 11 und die Leiterbahnen 13 aufgetragen. Auf die Kupferplatte 6 ist wiederum ein Lötstopplack 15 aufgetragen, welcher eine Lotabscheidung auf dem Kupfer bei der Belotung der Anschlußflächen für die SMD-Bauelemente verhindert. Unterhalb des Lötstopplacks 15 ist ein wärmeleitender Kleber 7 vorgesehen, der auf ein als Kühlkörper vorgesehenes Bodenteil 1 eines Steuergerätegehäuses aufgebracht ist. Bekannt ist auch, die Kupferplatte mittels schraubbarer Befestigungsmittel direkt an den Kühlkörper anzupressen. In jedem Fall wird die von dem Leistungsbauelement 3 erzeugte Wärme über die Durchkontaktierungen auf die großflächige Leiterbahn 11 und über die Isolationsschicht 5 an die Kupferplatte 6 abgeleitet. Von dort wird die Wärme durch den Lötstopplack 15 dann entweder direkt oder über den Wärmeleitkleber 7 an den Kühlkörper 1 abgegeben. Würde die Leiterplatte 2 ohne die Isolationsschicht 5 und die Kupfersenke 6 auf den Kühlkörper aufgebracht, so könnte ein Kurzschluß zwischen den potentialführenden Leiterbahnen 13 zu einer Beschädigung der Bauelemente führen. Nachteilig bei der in Fig. 1 gezeigten Anordnung ist aber, daß zur Aufbringung der Isolationsschicht 5 und der zusätzlichen Kupferplatte 6 zwei weitere separate Herstellungsschritte erforderlich sind.

In Fig. 2 ist eine erfindungsgemäße Anordnung zur Ableitung der Verlustwärme eines Leistungsbauelementes gezeigt, die vorzugsweise in ein elektronisches Steuergerät eines Kraftfahrzeuges eingesetzt wird. Wenigstens ein Leistungsbauelement, z.B. ein Leistungshalbleiter, ist auf eine großflächige Leiterbahn 10 auf der Oberseite 8 eines Trägersubstrats 2 aufgebracht, das eine Leiterplatte, ein Hybrid oder ein anderes, mit einer elektronischen Schaltung versehenes Substrat sein kann. In dem hier gezeigten Ausführungsbeispiel ist das Substrat 2 eine doppelseitig bestückte Leiterplatte. Wie in Fig. 2 weiter zu erkennen ist, ist ein Anschluß 14 des Leistungsbauelementes 3 mit einer vor der Leiterbahn 10 isolierten Anschlußleiterbahn 12 auf der Oberseite 8 der Leiterplatte 2 elektrisch verbunden. Auf der Unterseite 9 der Leiterplatte 2 ist eine zweite großflächige Leiterbahn 11 aufgebracht, die mit der ersten Leiterbahn 10 auf der Oberseite 8 über Durchkontaktierungen 4 wärmeleitend verbunden ist. Außerdem sind noch weitere, zur Schaltung gehörende, nicht dargestellte Leiterbahnen sowie einige Anschlußflächen für SMD-Bauelemente auf der Unterseite 9 vorgesehen. Wie in Fig. 2 dargestellt ist, sind auf der Unterseite 9 der Leiterplatte 2 weiterhin Leiterflächenstücke 17 vorgesehen, die zusammen mit den übrigen Leiterbahnen und Anschlußflächen und aus dem gleichen Material auf der Unterseite der Leiterplatte hergestellt sein können. Dies kann mit den üblichen bekannten Techniken geschehen. Bei dem in Fig. 2 gezeigten Ausführungsbeispiel wird von dem Leistungsbauelement 3 über die Durchkontaktierungen 4 eine Spannung auf die zweite großflächige Leiterbahn 11 übertragen. Die Leiterflächenstücke 17 sind deshalb von der Leiterbahn 11 isoliert auf dem Trägersubstrat angeordnet. Weiterhin ist ein Lötstopplack 9 in bekannter Weise auf die Unterseite 9 aufgebracht, wobei an den Stellen der Leiterflächenstücke 17 und der nicht dargestellten Anschlußflächen für SMD-Bauelemente Aussparungen im Lötstopplack vorgesehen sind. Bei der Herstellung der in Fig. 2 gezeigten Anordnung wird die Leiterplatte 2 mit der Unterseite 9 nach oben gewandt und in einer Lötpastendruckstation mit Lötpaste bedruckt. Dabei wird Lot auf die Leiterflächenstücke 17 und auf die Anschlußflächen für SMD-Bauelemente aufgetragen. Der Lötstopplack 15 verhindert, daß dabei Lot auf andere Schaltungsteile gelangt. Nach dem Aufdrucken des Lotes wird die Leiterplatte 2 einem Bestücker zugeführt, der die SMD-Bauelemente in die auf den Anschlußflächen aufgetragene Lotpaste auf der nach oben gewandten Unterseite 9 der Leiterplatte eindrückt. Anschließend durchläuft die Leiterplatte eine Reflowlötstation, in der das Lot aufgeschmolzen wird. Vorteilhaft werden dabei die SMD-Bauelemente mit den Anschlußflächen verlötet und gleichzeitig die Abstandselemente 17,18 gebildet. Dies geschieht, indem das auf den Leiterflächenstücken 17 aufgedruckte Lot 18 im Reflow-Ofen verflüssigt wird und sich durch die Oberflächenspannung des Lotes auf den Flächenstücken 17 Löthöcker oder Lötkappen definierter Größe bildet, deren Form nur von der Größe der Leiterflächenstücke 17 und der aufgedruckten Lotmenge abhängig ist. Insbesondere ist es mit dem beschriebenen Verfahren möglich, alle Abstandselemente mit einer genau definierten einheitlichen Höhe auszubilden. Besonders vorteilhaft dabei ist, daß der Lotpastendruckschritt und der Reflowlötschritt bei zweiseitig bestückten Leiterplatten ohnehin durchgeführt werden müssen, so daß zur Herstellung der Abstandselemente kein zusätzlicher Fertigungsschritt erforderlich ist. An Stelle des oben beschriebenen Herstellungsverfahrens ist es auch möglich, die Leiterflächenstücke z.B. in einem Wellenlötbad mit verflüssigtem Lot zu benetzen. Entscheidend ist, daß die Abstandselemente mit einer definierten Höhe hergestellt werden. Nach der Herstellung der Abstandselemente 17,18 wird ein wärmeleitfähiger Kleber 7 mit einer Dispens-Vorrichtung auf einen Kühlkörper 1 aufgebracht. In einem anderen Ausführungsbeispiel ist vorgesehen, an Stelle des Klebers eine beidseitig klebende Wärmeleitfolie einzusetzen. Als Kühlkörper dient ein Gehäuseteil des Steuergerätes, beispielsweise der Gehäuseboden. Die Leiterplatte 2 wird nun mit dem Kühlkörper 1 zugewandter Unterseite 9 auf den Kleber aufgesetzt und derart in Richtung des Kühlkörpers angedrückt, daß die Abstandselemente 17,18 in den Kleber 7 eindringen. Sie können dabei den Kühlkörper 1 berühren und sichern somit einen minimalen Abstand. Ein in Fig. 2 nicht dargestellte wannenförmige Vertiefung in dem Gehäuseboden des Steuergerätes nimmt dabei die auf der Unterseite der Leiterplatte angeordneten Bauelemente auf. Durch die Abstandselemente 17,18 wird zwischen der Unterseite der Leiterplatte und dem Kühlkörper ein definierter Spalt gebildet, der, wie in Fig. 2 gezeigt, von dem Kleber 7 vollständig ausgefüllt wird. Dadurch, daß die Abstandselemente mit einer definierten kleinen Höhe hergestellt werden können, kann der Spalt sehr klein gewählt werden, ohne daß der Kühlkörper die Leiterplattenunterseite berührt, wodurch sich die Wärmeableitung auf den Kühlkörper verbessert.

Anders als hier beschrieben, kann die in Fig. 2 gezeigte Anordnung aber auch dadurch hergestellt werden, daß z.B. die Leiterplatte 2 zuerst mit den Abstandselementen 17,18 auf den Kühlkörper aufgesetzt wird und anschließend erst ein kapillar fließfähige Kleber in den Spalt zwischen Leiterplattenunterseite und Kühlkörper eingebracht wird.

Die Abstandselemente 17,18 können vorteilhaft auch zum EMV-Schutz (Elektromagnetische-Verträglichkeit) der Anordnung dienen. Da die Abstandselemente aus einem elektrisch leitfähigen Material bestehen, wird durch sie ein elektrischer Kontakt zum Kühlkörper hergestellt, d.h. Abstandselemente und Kühlkörper befinden sich auf gleichem Potential. Wenn zumindest einige der Leiterflächenstücke 17 mit zur Schaltung gehörenden Leiterbahnen verbunden sind, kann über die Abstandselemente ein kurzer und damit abstrahlungsarmer Masseanschluß realisiert werden.

Ein weiteres Ausführungsbeispiel ist in Fig. 3 gezeigt. Gleiche Zahlen bedeuten gleiche Teile. Die in Fig. 3 geezeigte Anordnung unterscheidet sich von der in Fig. 2 gezeigten Anordnung dadurch, daß sich das Leistungsbauelement 3 und der Kühlkörper auf gleichem Potential befinden. Deshalb können bei dem in Fig. 3 gezeigten Beispiel die Leiterflächenstücke 17 vorteilhaft direkt in die zweite großflächige Leiterbahn 11 des Trägersubstrats 2 integriert werden. Die auf der zweiten Seite 9 des Trägersubstrats 2 aufgebrachte Lötstoppmaske 15 weist Ausnehmungen auf, welche die Leiterflächenstücke 17 definieren. Auf diesen Leiterflächenstücken werden wie oben beschrieben die Lötkappen 18 gebildet. Anschließend wird das Trägersubstrat über den Kleber 7 auf den Kühlkörper 1 aufgesetzt. Da sich das Leitstungsbauelement 3, die Leiterbahn 11 und der Kühlkörper 1 auf gleichem Potential befinden, wird durch die Abstandselemente 18 kein Kurzschluß erzeugt. Im Vergleich zur Fig. 2 kann der Wärmeübergang durch die Anordnung der Lötkappen 18 auf der zweiten großflächigen Leiterbahn 11 verbessert werden.

## Patentansprüche

1. Anordnung, insbesondere zur Verwendung in einem elektronischen Steuergerät, umfassend ein Trägersubstrat (2) und einen Kühlkörper (1), wobei das Trägersubstrat (2) auf einer ersten Seite (8) mit wenigstens einem auf einer ersten großflächigen Leiterbahn (10) angeordneten Leistungsbauelement (3) und auf einer dem Leistungsbauelement (3) gegenüberliegenden zweiten Seite (9) mit einer zweiten großflächigen Leiterbahn (11) versehen ist, wobei die erste großflächige Leiterbahn (10) und die zweite großflächige Leiterbahn (11) über wenigstens eine Durchkontaktierung (4) wärmeleitend miteinander verbunden sind und wobei das Trägersubstrat (1) mit der zweiten Seite (9) auf den Kühlkörper (1) wärmeleitend aufgebracht ist, **dadurch gekennzeichnet, daß** das Trägersubstrat (2) mit auf der zweiten Seite (9) des Trägersubstrats (2) angeordneten Abstandselementen (17,18) auf den Kühlkörper (1) aufgesetzt ist und in einem definierten Abstand zum Kühlkörper (1) gehalten wird, wobei der durch den Abstand gebildete Spalt zwischen Trägersubstrat (2) und Kühlkörper (1) mit einem wärmeleitenden Füllstoff (7) ausgefüllt ist.

2. Anordnung nach Anspruch 1, **dadurch gekennzeichnet, daß** als Abstandselemente Leiterflächenstücke (17) vorgesehen sind, die auf der zweiten Seite (9) des Trägersubstrats (2) angeordnet sind und mit einer definierten Menge Lot (18) beschichtet sind.

3. Anordnung nach Anspruch 2, **dadurch gekennzeichnet, daß** die zweite Seite (9) des Trägersubstrats (2) mit einem wenigstens die Leiterflächenstücke (17) aussparenden Lötstopplack (15) beschichtet ist.

4. Anordnung nach Anspruch 3, **dadurch gekennzeichnet, daß** sich das Leistungsbauelement (3) und der Kühlkörper (1) auf gleichem elektrischen Potential befinden und daß die Leiterflächenstücke (17) in der zweiten großflächigen Leiterbahn (11) integriert sind. (Fig. 3)

5. Anordnung nach Anspruch 1, **dadurch gekennzeichnet, daß** der wärmeleitende Füllstoff (7) ein aushärtbarer Wärmeleitkleber oder eine beidseitig klebende Wärmeleitfolie ist.

6. Anordnung nach Anspruch 2, **dadurch gekennzeichnet, daß** die Kontaktierung zwischen den mit Lot (18) beschichteten Leiterflächenstücken (17) und dem Kühlkörper (1) zugleich als Masseanschluß des Trägersubstrats (2) an den Kühlkörper dient.

7. Verfahren zur Herstellung einer Anordnung aus einem Trägersubstrat (2) und einem Kühlkörper (1), wobei das Trägersubstrat (2) auf einer ersten Seite (8) mit wenigstens einem auf einer ersten großflächigen Leiterbahn (10) angeordneten Leistungsbauelement (3) und auf einer dem Leistungsbauelement (3) gegenüberliegenden zweiten Seite (9) mit einer zweiten großflächigen Leiterbahn (11) versehen ist und wobei die erste großflächige Leiterbahn und die zweite großflächige Leiterbahn über wenigstens eine Durchkontaktierung (4) wärmeleitend miteinander verbunden sind und die zweite Seite (9) des Trägersubstrats (2) mit dem Kühlkörper (1) wärmeleitend verbunden wird, **gekennzeichnet durch** folgende Verfahrensschritte:
- Bereitstellen von Leiterflächenstücken (17) auf der zweiten Seite (9) des Trägersubstrats,
- Aufbringen eines wenigstens die Leiterflächenstücke (17) aussparenden Lötstopplacks (15) auf die zweite Seite (9) des Trägersubstrats (2),
- Beschichten der Leiterflächenstücke (17) mit einer definierten Menge Lot (18) und Herstellen von Abstandselementen (17,18) mit einer **durch** die aufgebrachte Lotmenge definierten Höhe,
- Aufsetzen des Trägersubstrats (2) mit den Abstandselementen (17, 18) auf den Kühlkörper (1) wobei zwischen der zweiten Seite (9) des Trägersubstrats (2) und dem Kühlkörper (1) ein wärmeleitender Füllstoff (7) eingebracht wird.

8. Verfahren nach Anspruch 7, **dadurch gekennzeichnet, daß** das Lot (18) in einer Lötpastendruckstation auf die Leiterflächenstücke (17) aufgedruckt wird und die Abstandselemente (17,18) durch anschließendes Reflowlöten des Trägersubstrats (2) in einer Reflowlötstation hergestellt werden.

9. Verfahren nach Anspruch 7, **dadurch gekennzeichnet, daß** als wärmeleitender Füllstoff (7) zunächst ein wärmeleitender, aushärtbarer Kleber oder eine beidseitig klebende Wärmeleitfolie auf den Kühlkörper (1) aufgetragen wird und anschließend das Trägersubstrats (2) auf den mit dem Kleber (7) beschichteten Kühlkörper derart aufgesetzt wird, daß die Abstandselemente (17,18) in den Kleber (7) eingedrückt werden, wobei sie mit der Lotschicht (18) den Kühlkörper (1) berühren können.

## Claims

1. Arrangement, in particular for use in an electronic control unit, comprising a carrier substrate (2) and a heat sink (1), the carrier substrate (2) being provided with at least one power component (3), which is arranged on a first large-area conductor track (10), on a first side (8) and with a second large-area conductor track (11) on a second side (9) opposite to the power component (3), the first large-area conductor track (10) and the second large-area conductor track (11) being connected to one another in a thermally conductive manner via at least one plated-through hole (4), and the carrier substrate (2) being applied by the second side (9) to the heat sink (1) in a thermally. conductive manner, **characterized in that** the carrier substrate (2) is placed with spacer elements (17, 18), which are arranged on the second side (9) of the carrier substrate (2), onto the heat sink (1) and is kept at a defined spacing from the heat sink (1), the gap, formed by the spacing, between carrier substrate (2) and heat sink (1) being filled with a thermally conductive filler (7).

2. Arrangement according to Claim 1, **characterized in that** the spacer elements provided are conductor area portions (17), which are arranged on the second side (9) of the carrier substrate (2) and are coated with a defined amount of solder (18).

3. Arrangement according to Claim 2, **characterized in that** the second side (9) of the carrier substrate (2) is coated with a soldering resist (15) having cutouts at least for the conductor area portions (17).

4. Arrangement according to Claim 3, **characterized in that** the power component (3) and the heat sink (1) are at the same electrical potential, and **in that** the conductor area portions (17) are integrated in the second large-area conductor track (11). (Fig. 3)

5. Arrangement according to Claim 1, **characterized in that** the thermally conductive filler (7) is a curable thermally conductive adhesive or a thermally conductive film which is adhesive on both sides.

6. Arrangement according to Claim 2, **characterized in that** the contact between the conductor area portions (17), which are coated with solder (18), and the heat sink (1) simultaneously serves as an earth connection of the carrier substrate (2) to the heat sink.

7. Method for the production of an arrangement comprising a carrier substrate (2) and a heat sink (1), the carrier substrate (2) being provided with at least one power component (3), which is arranged on a first large-area conductor track (10), on a first side (8) and with a second large-area conductor track (11) on a second side (9) opposite to the power component (3), and the first large-area conductor track and the second large-area conductor track being connected to one another in a thermally conductive manner via at least one plated-through hole (4), and the second side (9) of the carrier substrate (2) being thermally conductively connected to the heat sink (1), **characterized by** the following method steps:
- provision of conductor area portions (17) on the second side (9) of the carrier substrate,
- application of a soldering resist (15), having cutouts at least for the conductor area portions (17), to the second side (9) of the carrier substrate (2),
- coating of the conductor area portions (17) with a defined amount of solder (18), and production of spacer elements (17, 18) having a height which is defined by the applied amount of solder,
- emplacement of the carrier substrate (2) with the spacer elements (17, 18) on the heat sink (1), a thermally conductive filler (7) being introduced between the second side (9) of the carrier substrate (2) and the heat sink (1).

8. Method according to Claim 7, **characterized in that** the solder (18) is printed onto the conductor area portions (17) in a soldering paste printing station and the spacer elements (17, 18) are produced by subsequent reflow soldering of the carrier substrate (2) in a reflow soldering station.

9. Method according to Claim 7, **characterized in that** firstly a thermally conductive, curable adhesive or a thermally conductive film which is adhesive on both sides is applied, as thermally conductive filler (7), to the heat sink (1) and then the carrier substrate (2) is placed onto the heat sink coated with the adhesive (7) in such a way that the spacer elements (17, 18) are pressed into the adhesive (7), in which case they can touch the heat sink (1) with the layer (18) of solder.

## Revendications

1. Ensemble conçu en particulier pour être utilisé dans un appareil de commande électronique, comportant un substrat (2) et un élément de refroidissement (1), le substrat (2) étant doté sur une première face (8) d'au moins un composant de puissance (3), monté sur une première piste conductrice large (10) et, sur la deuxième face (9) opposée au composant de puissance (3), d'une deuxième piste conductrice large (11), la première piste conductrice large (10) et la deuxième piste conductrice large (11) étant reliées ensemble par au moins une connexion transversale thermoconductrice (4) et la deuxième face (9) du substrat (2) étant appliquée sur l'élément de refroidissement (1) selon un assemblage thermoconducteur,
**caractérisé en ce que**
le substrat (2) est monté sur l'élément de refroidissement (1) avec les éléments d'écartement (17, 18) fixés sur la deuxième face (9) du substrat (2), et maintenu à une distance pré-définie de l'élément de refroidissement (1), l'espace ainsi généré entre le substrat (2) et l'élément de refroidissement (1) étant comblé à l'aide d'une matière de remplissage thermoconductrice (7).

2. Ensemble selon la revendication 1,
**caractérisé en ce que**
des zones de surface conductrice (17) sont prévues comme élément d'écartement, celles-ci étant disposées sur la première face (9) du substrat (2) et recouvertes d'un métal d'apport (18) selon une quantité pré-définie.

3. Ensemble selon la revendication 2,
**caractérisé en ce que**
la deuxième face (9) du substrat (2) est revêtue d'un masquage (15) préservant les zones de surface conductrice (17) au moins.

4. Ensemble selon la revendication 3,
**caractérisé en ce que**
le composant de puissance (3) et l'élément de refroidissement (1) se trouvent sur un même potentiel électrique et les zones de surface conductrice (17) sont intégrées dans la deuxième piste conductrice large (11). (figure 3)

5. Ensemble selon la revendication 1,
**caractérisé en ce que**
la matière de remplissage thermoconductrice (7) est un adhésif durcissable thermoconducteur ou un adhésif double face thermoconducteur.

6. Ensemble selon la revendication 2,
**caractérisé en ce que**
le contact entre les zones de surface conductrice (17) recouvertes d'un métal d'apport (18) et l'élément de refroidissement (1) sert simultanément de connexion de masse du substrat (2) à l'élément de refroidissement.

7. Procédé pour la production d'un ensemble comportant un substrat (2) et un élément de refroidissement (1), le substrat (2) étant doté sur une première face (8) d'un composant de puissance (3) monté sur une piste conductrice large (10) et, sur la deuxième face (9) opposée au composant de puissance (3), d'une deuxième piste conductrice large (11), la première piste conductrice large et la deuxième piste conductrice large étant reliées ensemble par au moins une connexion transversale thermoconductrice (4), et la deuxième face (9) du substrat (2) étant appliquée sur l'élément de refroidissement (1) selon un assemblage thermoconducteur,
**caractérisé par**
les étapes suivantes:
- aménagement de zones de surface conductrice (17) sur la deuxième face (9) du substrat,
- application d'un masquage (15) préservant au moins les zones de surface conductrice (17) sur la deuxième face (9) du substrat (2),
- application sur les zones de surface conductrice (17) d'un métal d'apport (18) selon une quantité pré-définie, et réalisation d'éléments d'écartement (17, 18) présentant une hauteur déterminée par le métal d'apport,
- montage du substrat (2) avec les éléments d'écartement (17, 18) sur l'élément de refroidissement (1), une matière de remplissage thermoconductrice (7) étant ajoutée entre la deuxième face (9) du substrat (2) et l'élément de refroidissement (1).

8. Procédé selon la revendication 7,
**caractérisé en ce que**
le métal d'apport (18) est appliqué sur les zones de surface conductrice (17) à l'aide d'un appareil de dépôt de pâte à souder, les éléments d'écartement (17, 18) étant ensuite réalisés à l'aide d'un appareil de soudage reflow par soudage reflow du substrat (2).

9. Procédé selon la revendication 7,
**caractérisé en ce qu'**
un adhésif durcissable thermoconducteur ou un adhésif double face thermoconducteur est tout d'abord appliqué sur l'élément de refroidissement (1) comme matière de remplissage thermoconductrice (7), le substrat (2) étant ensuite placé sur l'élément de refroidissement recouvert par l'adhésif (7) de manière à enfoncer les éléments d'écartement (17, 18) dans l'adhésif (7) et réaliser un contact avec l'élément de refroidissement (1) par l'intermédiaire de la couche de métal d'apport (18).
